# FASCICULE DE BREVET EUROPEEN

(11) **EP 2 695 498 B1**
(45) Date de publication et mention de la délivrance du brevet: **28.07.2021**
(21) Numéro de dépôt: 12711910.5
(22) Date de dépôt: 05.04.2012
(51) Int. Cl.: H05K 1/02, H05K 3/46

(54) **CIRCUIT IMPRIMÉ FLEXRIGIDE SÉCURISÉ**
SICHERE STARR-FLEXIBLE LEITERPLATTE
SECURE FLEX RIGID PRINTED CIRCUIT

(30) Priorité: 08.04.2011 FR 1153056
(43) Date de publication de la demande: 12.02.2014
(73) Titulaire: Ingenico Group, 75015 Paris (FR)
(72) Inventeur: LAMBERT, Xavier, F-92500 Rueil-Malmaison (FR); MAYER, Laurent, F-95800 Courdimanche (FR); NGUYEN, Frédéric, F-95410 Groslay (FR); SULPICE, Pascal, F-91300 Massy (FR); WOLFF, Caroline, F-92150 Suresne (FR)
(74) Mandataire: Vidon Brevets & Stratégie
(86) Numéro de dépôt international: PCT/EP2012/056338
(87) Numéro de publication internationale: WO 2012/136797

(56) Documents cités:
- EP-A1- 1 951 016
- EP-A1- 2 262 352
- US-A1- 2011 036 619
- None

## Description

### 1 DOMAINE DE L'INVENTION

L'invention concerne les systèmes électroniques de plusieurs circuits imprimés. De tels systèmes sont par exemple utilisés dans des dispositifs électroniques tels que des terminaux de paiement, de lecteurs de cartes à puces, des consoles de jeux ou encore des lecteurs multimédia. Cette liste illustre très partiellement la multitude de dispositifs du quotidien qui comprennent des systèmes électroniques comprenant généralement plusieurs circuits imprimés.

La nécessité d'utiliser plusieurs circuits imprimés dans un système électronique est généralement dictée par des impératifs liés au produit dans lequel ce système électronique est destiné à être positionné. En effet en fonction de la forme du produit, il peut être nécessaire de prévoir plusieurs circuits imprimés qui vont être reliés les uns aux autres.

La forme du produit n'est pas nécessairement la seule raison pour laquelle il peut être nécessaire d'utiliser un système comprenant plusieurs circuits imprimés. Cette nécessité peut également être guidée par des impératifs liés à la place disponible.

### 2 SOLUTIONS DE L'ART ANTERIEUR

Un des problèmes qui se pose avec les systèmes électroniques comprenant plusieurs circuits imprimés est celui de la liaison entre ces circuits imprimés. En effet, pour pouvoir fournir les fonctions attendues, il est généralement nécessaire de relier les circuits imprimés composant le système. Pour relier les circuits imprimés, on utilise des connecteurs. Ces connecteurs posent des problèmes d'une part de fiabilité et d'autre part de sécurité. De fiabilité d'abord : les connecteurs subissent des contraintes mécaniques plus ou moins importantes et nécessitent un assemblage (une soudure par exemple). De sécurité ensuite : il est souvent envisageable d'utiliser le connecteur comme une voie d'accès aux signaux échangés entre les circuits électroniques.

Ce problème de sécurité est particulièrement gênant dans les dispositifs qui gèrent des données confidentielles comme les terminaux de paiement, les lecteurs de cartes de paiement, etc. En effet, des signaux sensibles transitent entre les circuits imprimés. Ces signaux sensibles sont par exemple représentatifs d'un compte bancaire, d'un code secret (« pin code »). Ce problème de sécurité doit donc absolument être résolu.

En d'autres termes, les problèmes rencontrés par les circuits connus sont liés aux interconnexions mécaniques indispensables pour permettre d'une part la liaison de plusieurs circuits imprimés entre eux et d'autre part pour offrir des formes originales aux produits une fois assemblés.

Or ces interconnexions mécaniques (qui sont réalisées sous la forme de connecteur carte à carte, lorsque deux cartes doivent être interconnectées, ou sous la forme d'une nappe flexible connectée à deux connecteurs présents sur chacune des deux cartes) nécessitent des protections particulières pour empêcher l'espionnage des signaux qui y transitent.. Dans le premier cas, trois éléments doivent être sécurisés : les deux cartes (ou à tout le moins les deux circuits imprimés de chaque carte) et le connecteur. Dans le deuxième cas, cinq éléments doivent être sécurisés : les deux cartes (ou à tout le moins les deux circuits imprimés de chaque carte), le connecteur monté sur chacune des cartes et la nappe utilisée pour relier les deux connecteurs.

Ainsi, des cartes à circuit imprimé souples et rigides ont été développées. Il s'agit de circuits composés de plaquettes à circuit imprimé souples et rigides : les parties rigides servent à accueillir les composants tandis que les parties souples servent à établir des connexions électriques entre les parties rigides. Cette conception permet d'économiser des connecteurs débrochables et les circuits peuvent alors être réalisés sur de petits espaces.

Ces liaisons flexibles permettent de positionner et de relier les circuits rigides qui supportent les composants. Ce système est fonctionnel dans des configurations spatiales complexes et permet de gagner de la place.

De tels circuits sont appelés circuits « flexrigides ». Cependant, l'utilisation de ces circuits n'est pas étendue à toutes les branches de l'industrie, notamment les dispositifs de paiement, pour des problèmes de sécurisation. L'état de l'art comprend les documents EP-A1-1951016 et US-A1-2011036619.

Il existe donc un besoin de fournir un tel circuit flexrigide qui soit sécurisé.

### 3 RESUME DE L'INVENTION

L'invention ne pose pas ces problèmes liés aux systèmes de l'art antérieur. En effet, l'invention concerne un circuit imprimé comprenant au moins une partie rigide et au moins une partie flexible, selon la revendication 1.

Ainsi, à la différence des circuits imprimés de l'art antérieur, la partie flexible est sécurisée.

Selon un mode de réalisation particulier ladite partie flexible comprend plus particulièrement, une première couche de protection, une première couche de transmission, située sous la première couche de protection, une deuxième couche de transmission, située sous la première couche de transmission et une deuxième couche de protection, située sous la deuxième couche de transmission, chacune desdites couches étant séparée de la couche précédente par l'intermédiaire d'une couche isolante.

Selon une caractéristique particulière, ladite couche de protection comprend un blindage de cuivre.

Selon une caractéristique particulière, ladite couche de protection comprend un treillis de cuivre.

Selon une caractéristique particulière, au moins certaines desdites couches sont interconnectées par l'intermédiaire de vias.

Selon un autre aspect, l'invention concerne un terminal électronique de paiement. Selon l'invention, un tel terminal de paiement, comprend au moins un circuit imprimé selon la revendication 1.

### 4 LISTE DES FIGURES

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- La figure 1 illustre une vue de dessus du circuit imprimé flex/rigide sécurisé de l'invention
- La figure 2 présente une vue de coupe d'une portion d'un circuit imprimé flex/rigide sécurisé selon l'invention.
- Les figures 3, 4 et 5 illustrent différents modes de réalisation des circuits imprimés flex/rigide sécurisés selon l'invention.

### Description détaillée de l'invention

### 4.1 Rappel du principe de l'invention

Il est communément admis que le coût de la sécurisation d'un système augmente exponentiellement avec le nombre d'éléments à sécuriser dans le système : c'est particulièrement le cas dans un système tel que celui présenté dans lequel chaque élément (carte, connecteur, nappe) doit faire l'objet d'une sécurisation particulière. La sécurisation d'une nappe n'est en effet pas la même opération que la sécurisation d'un connecteur ou d'une carte. Les coûts de sécurisation sont donc multipliés.

Il existe donc un besoin pour la fourniture d'un système qui offre les mêmes avantages que les systèmes à base de cartes séparées et de connecteurs tout en ne présentant pas les inconvénients de l'art antérieur en matière de sécurisation (moyens à mettre en œuvre et coûts).

L'invention propose donc de sécuriser ces systèmes en utilisant, en lieu et place des connecteurs traditionnels et des nappes, un circuit imprimé « flex/rigide » sécurisé. Ainsi, l'invention permet de sécuriser le circuit imprimé à moindre coût.

Par la suite, on présente notamment un mode de réalisation d'un circuit imprimé « flex/rigide » sécurisé. Il est clair cependant que l'invention ne se limite pas à mode de réalisation particulier, mais peut également être mise en œuvre dans de nombreux autres modes de réalisation.

### 4.2 Circuit imprimé « flex/rigide » sécurisé

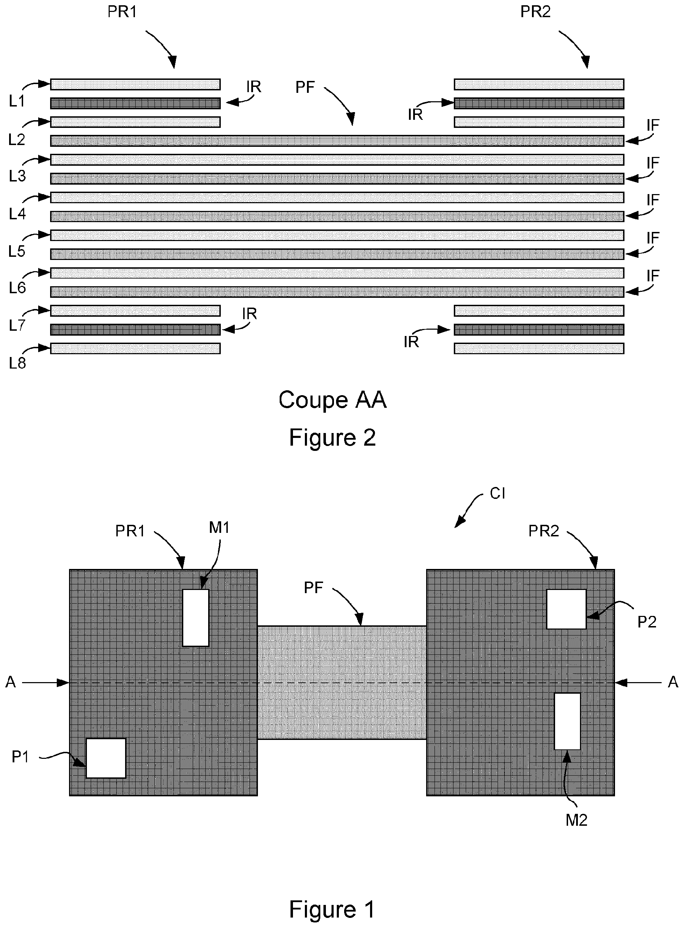

On présente, en relation avec les figures 1 et 2, un mode de réalisation d'un circuit imprimé « flex/rigide » sécurisé au sens de l'invention.

Comme déjà évoqué, un tel circuit « flex/rigide » sécurisé comprend au moins une partie rigide (PR1, PR2), sur laquelle, par exemple des composants électroniques sont montés (microprocesseurs P1, P2, mémoire M1, M2, etc.) et au moins une partie flexible (PF) qui assure une fonction de connexion entre les parties rigides (elles ont la fonction des « nappes », au sens électronique du terme). Un tel circuit imprimé est par exemple construit selon une méthode reprenant plus ou moins les principes généraux de la méthode décrite dans le document de brevet « US 6,745,463 ».

Plus particulièrement, à la différence de la technique décrite dans le document « US 6,745,463 », le circuit « flex/rigide » sécurisé intègre une pluralité de couches (figure 2). Plus particulièrement, au lieu de proposer une partie flexible mono couche (c'est à dire n'intégrant qu'une seule épaisseur de « cuivre » (c'est-à-dire un seul circuit équivalent à une nappe), la partie flexible est, selon l'invention, « multicouche » et est intégrée aux parties rigides. Cette multitude de couches permet d'assurer que la fonction de connexion de la partie flexible ne puisse pas être sujette à piratage.

Plus particulièrement, en relation avec la figure 2, les couches comprenant les pistes de cuivre (L1 à L8) sont séparées les unes des autres par des couches de matériaux adhésifs et isolant (couches IR et IF). Les couches IR sont des couches isolantes rigides, qui délimitent les parties rigides (PR1, PR2) du circuit imprimé (CI). Les couches isolantes IF sont des couches isolantes flexibles qui offrent sa flexibilité à la partie flexible.

Selon une caractéristique particulière de l'invention, chaque couche de la pluralité de couches est associée à une fonction particulière. Le passage des signaux de sécurité (L4 et L5) est protégé entre les deux circuits imprimés rigides. La sécurisation des signaux transitant d'un circuit imprimé à un autre est assurée par la mise en place dans les couches L3 et L6 de pistes de détection d'intrusion physique et électrique. Ces couches L3 et L6 peuvent comprendre, avantageusement, des treillis de cuivre qui permettent de détecter toute tentative de grattages, de perçage, etc. Les couches sont reliées entre elles par l'intermédiaire de « vias » pour assurer une continuité dans la protection apportée à la partie flexible et celle apportée à la partie rigide.

Cette sécurité peut être améliorée (au niveau électromagnétique), selon une caractéristique complémentaire par l'ajout de deux couches supplémentaires, sous la forme de deux plans de masse, placées au dessus des couches destinées à la détection d'intrusion physique et électrique.

Cette solution peut être étendue à la protection physique et électrique du circuit imprimé dans sa globalité, avec l'ajout de parties flexibles ou rigides qui servent de barrière, une fois le dispositif électronique monté ou assemblé.

Cette solution peut aussi être étendue à toutes liaisons avec des éléments du dispositif électronique pouvant être traditionnellement connectées par une nappe flexible et dont les signaux nécessitent d'être sécurisés (Tête ISO, afficheurs, smart card...).

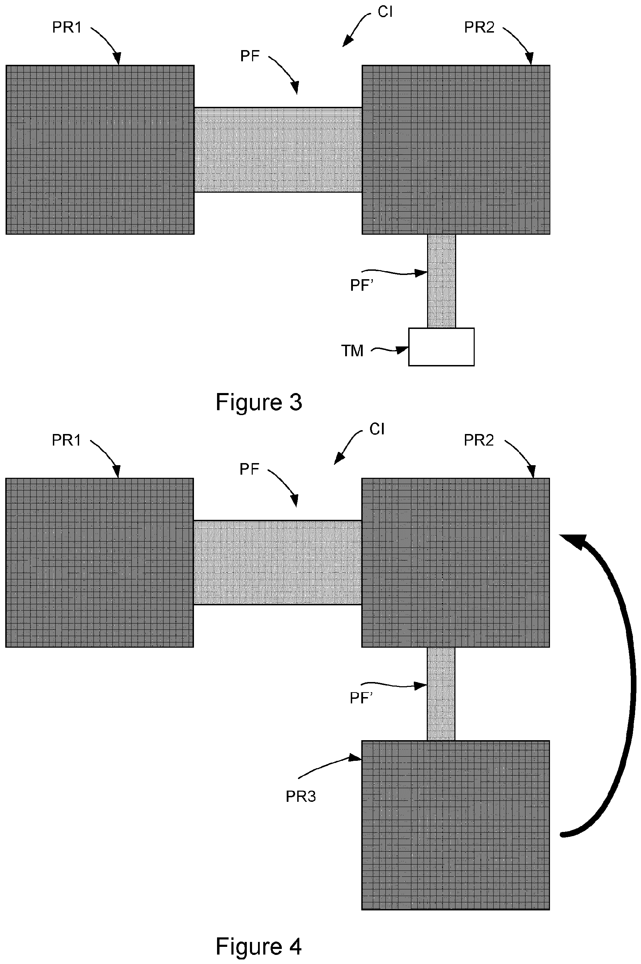

Les figures 3, 4 et 5 illustrent ce propos. Les références des figures précédentes ont été conservées pour plus de clarté/

Dans la figure 3, deux parties flexibles sont utilisées (PF, PF'). La première partie flexible (PF) permet de relier les deux parties rigides (PR1 et PR2). La deuxième partie flexible (PF') permet de relier une tête de lecture (par exemple une tête de lecture magnétique TM) à la deuxième partie rigide PR2. Cette tête de lecture TM est directement montée (ou soudée) sur la deuxième partie flexible PF'. On assure ainsi une protection des signaux qui proviennent de la tête de lecture.

Dans la figure 4, deux parties flexibles sont utilisées (PF, PF'). La première partie flexible PF permet de relier deux parties rigides (PR1, PR2). La deuxième partie flexible PF' permet de relier la deuxième partie rigide PR2 à une troisième partie rigide PR3. Cette troisième partie rigide PR3 est utilisée comme une protection de la deuxième partie rigide PR2 au dessus de laquelle la troisième partie rigide PR3 vient prendre place (sens de la flèche) lorsque le dispositif qui comprend le circuit imprimé (CI) est monté. La fonction de la deuxième partie flexible PF' est ici d'assurer une liaison inviolable entre les circuits et assurer la sécurité de l'ensemble.

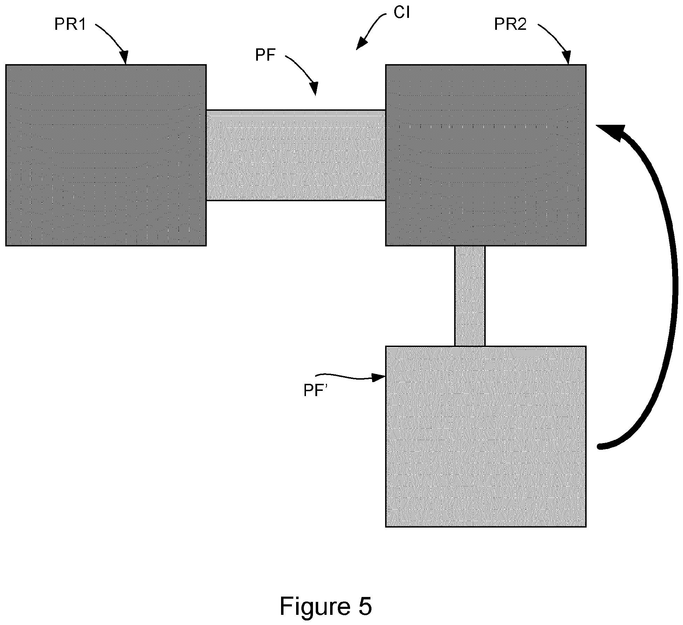

Dans la figure 5, deux parties flexibles sont utilisées (PF, PF'). La première partie flexible PF permet de relier deux parties rigides (PR1, PR2). La deuxième partie flexible PF' a une forme prédéterminée qui permet de recouvrir la deuxième partie rigide PR2 au dessus de laquelle la deuxième partie flexible PF' vient prendre place (sens de la flèche) lorsque le dispositif qui comprend le circuit imprimé (CI) est monté. L'avantage, par rapport au mode de réalisation préalablement présenté en relation avec la figure 4, est que la deuxième partie flexible PF' peut être déformée lors du montage du dispositif sans que cela ne génère de problème particulier.

### 4.3 Autres caractéristiques optionnelles et avantages

Les modes de réalisation précédents on montré que l'invention permet de s'affranchir des solutions traditionnelles utilisées dans les terminaux de paiement pour relier les circuits imprimés (connecteurs, fils....) et pour protéger les signaux sensibles.

Ainsi cette solution permet :
- une amélioration de la protection des signaux sensibles avec :
   - le masquage des signaux sensibles suite à leur intégration dans les couches internes du circuit imprimé « flex/rigide » de l'invention et l'utilisation, selon une caractéristique complémentaire, de vernis opaques sur les couches externes ;
   - une résolution (largeur de pistes et distance inter piste) des pistes (qui conduisent les signaux sensibles) supérieure aux solutions traditionnelles proposées avec les connecteurs. Une résolution plus basse rend difficiles et délicates les tentatives d'intrusion ;
- une simplification des opérations d'assemblages avec :
   - l'élimination des composants traditionnels à utiliser pour interconnecter les circuits imprimés entre eux et des opérations d'assemblage associées, et donc une diminution de coût ;
   - l'élimination des solutions de protection mises en œuvre lors de l'emploi de composants traditionnels pour éviter les intrusions ;
- une fiabilisation des interconnexions en :
   - éliminant des défauts inhérents aux opérations d'assemblage des composants traditionnels (problèmes de fiabilité des soudures) ;
   - réduisant le nombre d'interconnections (connecteur/PCB, connecteur/connecteur, ....) ;
- une amélioration de l'ergonomie des terminaux (forme du produit) par la liberté d'inclinaison entre les deux circuits imprimés rigides ;
- une possibilité de faire transiter aisément de la puissance entre les divers PCB (ou éléments connectés) sans multiplication des pistes comme avec un circuit flexible standard.

## Revendications

1. Circuit imprimé (CI) comprenant au moins une partie rigide (PR1, PR2) et au moins une partie flexible, ladite partie flexible (PF) comprenant au moins une couche comprenant au moins une piste de cuivre de transmission de signal (L4, L5), dite couche de transmission et au moins deux couche de protection (L3, L6), ladite au moins une couche de transmission étant séparée de chacune des au moins deux couches de protection par l'intermédiaire d'au moins une couche isolante (IF), **caractérisé en ce que** lesdites au moins deux couches de protection comprennent au moins une piste de connexion avec une couche de protection correspondante de la partie rigide, lesdites au moins deux couches *de protection sont reliées entre elles par l'intermédiaire de vias.*

2. Circuit imprimé selon la revendication 1, **caractérisé en ce que** ladite partie flexible comprend plus particulièrement, une première couche de protection, une première couche de transmission, située sous la première couche de protection, une deuxième couche de transmission, située sous la première couche de transmission et une deuxième couche de protection, située sous la deuxième couche de transmission, chacune desdites couches étant séparée de la couche précédente par l'intermédiaire d'une couche isolante.

3. Circuit imprimé selon la revendication 1 **caractérisé en ce que** ladite couche de protection comprend un blindage de cuivre.

4. Circuit imprimé selon la revendication 1 **caractérisé en ce que** ladite couche de protection comprend un treillis de cuivre.

5. Circuit imprimé selon la revendication 1 **caractérisé en ce qu'**au moins certaines desdites couches sont interconnectées par l'intermédiaire de vias.

6. Terminal électronique de paiement, **caractérisé en ce qu'**il comprend au moins un circuit imprimé selon la revendication 1.

## Patentansprüche

1. Leiterplatte (CI), umfassend mindestens einen starren Teil (PR1, PR2) und mindestens einen flexiblen Teil, wobei der flexible Teil (PF) mindestens eine Schicht aufweist, die mindestens eine Kupferbahn zur Signalübertragung (L4, L5), Übertragungsschicht genannt, und mindestens zwei Schutzschichten (L3, L6) aufweist, wobei die mindestens eine Übertragungsschicht von jeder der mindestens zwei Schutzschichten durch mindestens eine Isolierschicht (IF) getrennt ist, **dadurch gekennzeichnet, dass** die mindestens zwei Schutzschichten mindestens eine Bahn zur Verbindung mit einer entsprechenden Schutzschicht des starren Teils aufweisen, wobei die mindestens zwei Schutzschichten durch Durchkontaktierungen miteinander verbunden sind.

2. Leiterplatte nach Anspruch 1, **dadurch gekennzeichnet, dass** der flexible Teil insbesondere eine erste Schutzschicht, eine erste Übertragungsschicht, die sich unter der ersten Schutzschicht befindet, eine zweite Übertragungsschicht, die sich unter der ersten Übertragungsschicht befindet, und eine zweite Schutzschicht aufweist, die sich unter der zweiten Übertragungsschicht befindet, wobei jede der Schichten von der vorherigen Schicht durch eine Isolierschicht getrennt ist.

3. Leiterplatte nach Anspruch 1, **dadurch gekennzeichnet, dass** die Schutzschicht eine Kupferabschirmung aufweist.

4. Leiterplatte nach Anspruch 1, **dadurch gekennzeichnet, dass** die Schutzschicht ein Kupfergeflecht aufweist.

5. Leiterplatte nach Anspruch 1, **dadurch gekennzeichnet, dass** mindestens einige der Schichten durch Durchkontaktierungen miteinander verbunden sind.

6. Elektronisches Zahlungsterminal, **dadurch gekennzeichnet, dass** es mindestens eine Leiterplatte nach Anspruch 1 aufweist.

## Claims

1. Printed circuit (CI) comprising at least one rigid portion (PR1, PR2) and at least one flexible portion, the flexible portion (PF) comprising at least one layer which comprises at least one copper signal transmission track (L4, L5), referred to as the transmission layer, and at least two protection layers (L3, L6), the at least one transmission layer being separated from each of the at least two protection layers by means of at least one insulating layer (IF), **characterised in that** the at least two protection layers comprise at least one connection track with a corresponding protection layer of the rigid portion, the at least two protection layers are connected to each other by means of vias.

2. Printed circuit according to claim 1, **characterised in that** the flexible portion comprises more specifically a first protection layer, a first transmission layer located below the first protection layer, a second transmission layer located below the first transmission layer, and a second protection layer located below the second transmission layer, each of the layers being separated from the preceding layer by means of an insulating layer.

3. Printed circuit according to claim 1, **characterised in that** the protection layer comprises a copper shield.

4. Printed circuit according to claim 1, **characterised in that** the protection layer comprises a copper mesh.

5. Printed circuit according to claim 1, **characterised in that** at least some of the layers are interconnected by means of vias.

6. Electronic payment terminal, **characterised in that** it comprises at least one printed circuit according to claim 1.
